# EUROPEAN PATENT APPLICATION

(11) **EP 2 441 860 A1**
(43) Date of publication of application: **18.04.2012**
(21) Application number: 10187466.7
(22) Date of filing: 13.10.2010
(51) Int. Cl.: C23C 16/46, C23C 16/455

(54) **Apparatus and method for atomic layer deposition on a surface**

(71) Applicant: Nederlandse Organisatie voor Toegepast -Natuurwetenschappelijk Onderzoek TNO, 2628 VK Delft (NL)
(72) Inventor: Knaapen, Raymond Jacobus Wilhelmus, 2628 VK Delft (NL); Poodt, Paulus Willibrordus George, 2628 VK Delft (NL); Smeltink, Jeroen Anthonius, 2628 VK Delft (NL); Olieslagers, Ruud, 2628 VK Delft (NL); Galaktionov, Oleksiy Sergiyovich, 2628 VK Delft (NL)
(74) Representative: Jansen, Cornelis Marinus

(57) **Abstract**

Apparatus for atomic layer deposition on a surface of a substrate, the apparatus comprising: a deposition member; a substrate table for supporting the substrate; a first reactant injector for supplying a first reactant; a second reactant injector for supplying a second reactant; a gas injector being arranged for creating, by means of gas injected by the gas injector, a gas barrier and optionally being arranged for creating a gas bearing; a heater for heating the gas that is to be injected by the gas injector; and an additional heater for heating the deposition member and the substrate table, and for heating the substrate. The deposition member has a gas inlet for the gas that is to be injected by the gas injector. The heater is provided outside the deposition member. The gas transported from the gas inlet is heated by the heater before said gas enters the gas inlet.

## Description

The invention relates to an apparatus for atomic layer deposition. In particular, the invention relates to an apparatus for atomic layer deposition on a surface of a substrate, the apparatus comprising: a deposition member; a substrate table for supporting the substrate; a first reactant injector for supplying a first reactant from a first supply to a first cavity being arranged in the deposition member so that in use the first cavity is facing the surface and/or the substrate table; a second reactant injector for supplying a second reactant from a second supply to a second cavity being arranged in the deposition member so that in use the second cavity is facing the surface and/or the substrate table; a gas injector being arranged in the deposition member so that in use the gas injector is facing the substrate and/or the substrate table, the gas injector being arranged for creating, by means of gas injected by the gas injector, a gas barrier at least between the first cavity and the second cavity, and optionally being arranged for creating, by means of the gas injected by the gas injector, a gas bearing between the deposition member and the surface of the substrate and/or between the deposition member and the substrate table, wherein, in use, the gas bearing is bearing the deposition member with respect to the surface of the substrate and/or the substrate table.

Such an apparatus is known from EP2159304. In a method using the apparatus for atomic layer deposition a first and a second reactant (precursor) may sequentially be brought into contact with the surface of a substrate. Two half reactions at the surface of the reactants may result in one monolayer deposited on the surface. By repeating these reactions layer thickness can be controlled extremely well.

Furthermore, an apparatus for atomic layer deposition provided with a gas injector for creating a gas barrier at least between the first cavity and the second cavity may provide a significant advantage. The gas barrier may, in use, separate the first reactant from the second reactant. For example, multiple atomic layers may be deposited by repeatedly transporting a substrate along the first cavity containing the first reactant and the second cavity containing the second reactant.

Furthermore, the gas injector may be advantageously employed for creating a gas bearing between a deposition member, and a movable substrate and/or a substrate table.

A novel wish to carry out atomic layer deposition at an increased temperature, e.g. a temperature larger than 1000 degrees Celsius, e.g. around 1100 degrees Celsius, imposes novel requirements to apparatuses for atomic layer deposition. In particular, such requirements may result from increased thermo-mechanical deformations that may occur at the increased temperature. Novel requirements may also relate to insufficient temperature-resistance of materials of known apparatuses for atomic layer deposition. In the prior art, an apparatus for carrying out atomic layer deposition at a temperature larger than 1000 degrees Celsius is lacking.

It is therefore an object of the invention to provide an apparatus for atomic layer deposition which may enable atomic layer deposition at an increased temperature.

According to an aspect of the invention, there is provided an apparatus for atomic layer deposition on a surface of a substrate, the apparatus comprising: a deposition member; a substrate table for supporting the substrate; a first reactant injector for supplying a first reactant from a first supply to a first cavity being arranged in the deposition member so that in use the first cavity is facing the surface and/or the substrate table; a second reactant injector for supplying a second reactant from a second supply to a second cavity being arranged in the deposition member so that in use the second cavity is facing the surface and/or the substrate table; a gas injector, at least partly being arranged in the deposition member so that in use the gas injector is facing the substrate and/or the substrate table, the gas injector being arranged for creating, by means of gas injected by the gas injector, a gas barrier at least between the first cavity and the second cavity, and optionally being arranged for creating, by means of the gas injected by the gas injector, a gas bearing between the deposition member and the surface of the substrate and/or between the deposition member and the substrate table,
wherein, in use, the gas bearing is bearing the deposition member with respect to the surface of the substrate and/or the substrate table; a heater for heating the gas that is to be injected by the gas injector; and an additional heater for heating the deposition member and the substrate table, and for heating the substrate, optionally via the substrate table; wherein the deposition member and optionally the substrate table have a gas inlet for the gas that is to be injected by the gas injector, wherein the gas injector is in fluid communication with the gas inlet for transporting the gas from the gas inlet; wherein the heater is provided outside the deposition member and the substrate table, so that, in use, the gas transported from the gas inlet and injected by the gas injector is heated by the heater before said gas enters the gas inlet and/or the deposition member when, in use, the deposition member is heated by the additional heater.

By means of the heater that is provided outside the deposition member and the substrate table, a working temperature of the gas, e.g. a temperature larger than 800 or 1000 degrees Celsius, can be substantially reached before the gas enters the inlet and thus enters the deposition member and optionally the substrate table. Thus, the gas transported from the gas inlet and injected by the gas injector may substantially have reached the gas working temperature before said gas enters the gas inlet and/or the deposition member. Hence, the deposition member and optionally the substrate table, when heated by the additional heater, can receive heated gas from the inlet. As a result, substantial thermo-mechanical deformation induced by cooling of the substrate, the deposition member and/or the substrate table by the gas after the gas has passed the inlet, may be substantially prevented.

Thus the gas injected by the gas injector does not significantly disturb a temperature distribution in the apparatus and temperature gradients in and/or around and/or in a vicinity of the substrate may be controlled as a result of the preheated gas injected by the gas injector. In particular this aims to prevent warping of the substrate and or the substrate table the vicinity of the air bearing, which could distort the bearing function and may go at the expense of yield of the atomic layer deposition process, or even may make a satisfactory deposition process practically impossible. If a separation between the deposition member and the apparatus becomes relatively small, e.g. enabled by the gas bearing, requirements to allowed thermo-mechanical deformations of the apparatus may become even more strict.

The deposition member and the substrate may be arranged in the apparatus to be movable, e.g. rotatable, with respect to each other. E.g., the deposition member and the substrate table may be arranged in the apparatus to be movable, e.g. rotatable, with respect to each other. Optionally, movement, e.g. rotation, of the deposition member on the one hand, and the substrate and/or the substrate table on the other hand, may be enabled by means of the gas bearing.

Preferably, the first reactant injector is arranged in the deposition member so that in use the first reactant injector is facing the surface and/or the substrate table. Preferably, the second reactant injector is arranged in the deposition member so that in use the second reactant injector is facing the surface and/or the substrate table. The gas barrier may, in use, separate the first reactant from the second reactant. The gas barrier may, in use, separate the first reactant from the second reactant by being positioned at least in between the first cavity and the second cavity.

Atomic layer deposition of e.g. materials suitable for manufacturing of light emitting diodes may require increased, i.e. relatively high, temperatures, e.g. larger than 1000 degrees Celsius, e.g. around 1100 degrees Celsius.

Preferably the apparatus comprises a controller for controlling heat supplied by the heater and the additional heater, wherein the heater is arranged for heating the gas that is to be injected by the gas injector to a gas working temperature; and wherein the additional heater is arranged for heating the deposition member to a deposition member working temperature and for heating the substrate table to a substrate table working temperature, and for heating the substrate to a substrate working temperature, optionally via the substrate table; wherein the controller is arranged for controlling, preferably for substantially equalizing, the gas working temperature, the deposition member temperature, the substrate table working temperature, and/or the substrate working temperature. Substantially equalizing said temperatures may comprise controlling said temperatures within a range of plus or minus 50 degrees Celsius, plus or minus 100 degrees Celsius, or plus or minus 250 degrees Celsius, with respect to a temperature set point. The temperature set point may e.g. be 800, 900, 1000 or 1100 degrees Celsius. By means of such equalizing, excessive thermo-mechanical deformations may be prevented.

According to another aspect of the invention, there is provided an apparatus for atomic layer deposition on a surface of a substrate, the apparatus comprising:
a first reactant injector for supplying a first reactant from a first supply to a first cavity arranged within the apparatus so that in use the first cavity is facing the surface and/or a substrate table of the apparatus for supporting the substrate;
a second reactant injector for supplying a second reactant from a second supply to a second cavity arranged within the apparatus so that in use the second cavity is facing the surface and/or the substrate table; and,
a gas injector arranged within the apparatus so that in use the gas injector is facing the surface and/or the substrate table for creating, by means of gas injected by the gas injector, a gas barrier at least between the first cavity and the second cavity; wherein the apparatus comprises a heater for heating the gas that is to be injected by the gas injector.

By heating the gas the temperature within the apparatus, and therefore the temperature at the substrate surface, may be increased to initiate the reaction forming the atomic layer. The chemical deposition reactions during atomic layer deposition may be improved by an increased temperature.

The apparatus according to one or both of said aspects may be used for the production of light emitting diodes or photo voltaic cells.

The apparatus according to said other aspect may be provided with the substrate table for supporting the substrate. The first reactant injector, the second reactant injector and the gas injector may be provided in a deposition member of the apparatus. Alternatively or additionally, a gas bearing may, in use, be bearing the deposition member with respect to the surface of the substrate and/or the substrate table. The apparatus may comprise an additional heater for heating of the substrate

For the apparatus according to one or both of said aspects, it may optionally hold that the gas injector is provided in between the first and second reactant injector so as to separate the first and the second reactants. In this way formation of a direct reaction product of the first and second reactant at undesired positions, e.g. away from the substrate surface and/or the substrate table, may be substantially prevented. The substrate table may be a rotary table for in use rotating the substrate. The substrate table may be provided with a gas bearing for supporting the substrate. In this way the substrate may be moveable within the apparatus, avoiding the necessity of a moveable substrate table. The substrate table may have a substrate support surface facing the deposition member.

For the apparatus according to one or both of said aspects, it may optionally hold that the heater comprises a first induction heater, the first induction heater being provided with coils surrounding a body with channels for heating the gas. The additional heater may comprise a second induction heater being provided with coils surrounding the substrate table and/or the deposition member. The apparatus may be provided with a heat shield. The heat shield may define an inside of the heat shield being provided with the deposition member and the substrate table and an outside of the heat shield being provided with the coils of the second induction heater. The heat shield comprises a reflective material. The heat shield may comprise multi layers of reflective material. The heat shield may be provided between the body with channels and the first inductor. The substrate table may be moveable with respect to the deposition member so as to open the apparatus and to allow the substrate to be loaded or removed.

The invention further relates to a method for atomic layer deposition on a surface of a substrate.

According to a further aspect of the invention, there is provided a method for atomic layer deposition on a surface of a substrate, the method comprising: providing a deposition member; supporting the substrate by means of a substrate table; supplying a first reactant from a first supply to a first deposition cavity that faces the substrate and/or the substrate table so as to bring the first reactant in contact with the surface; supplying a second reactant from a second supply to a second deposition cavity that faces the substrate and/or the substrate table so as to bring the second reactant in contact with the surface; injecting a gas via a gas injector to the surface and/or the substrate table, and, by means of the gas injected by the gas injector, creating a gas barrier at least between the first deposition cavity and the second deposition cavity and optionally creating a gas bearing between the deposition member and the surface of the substrate and/or between the deposition member and the substrate table, so that the gas bearing is bearing the deposition member with respect to the surface of the substrate and/or the substrate table; providing a heater for heating the gas before injection by the gas injector; providing an additional heater for heating the deposition member and the substrate table, and for heating the substrate, optionally via the substrate table; transporting the gas that is to be injected by the gas injector in the deposition member from a gas inlet of the deposition member that is in fluid communication with the gas injector; wherein the method comprises providing the heater outside the deposition member and the substrate table, and comprises heating the gas transported from the gas inlet and injected by the gas injector before said gas enters the gas inlet and/or the deposition member when the deposition member is heated by the additional heater.

According to an additional aspect of the invention, there is provided a method for atomic layer deposition on a surface of a substrate, the method comprising:
supplying a first reactant from a first supply to a first deposition cavity so as to bring the first reactant in contact with the surface;
supplying a second reactant from a second supply to a second deposition cavity so as to bring the second reactant in contact with the surface; and,
supplying, e.g. injecting, a gas via a gas injector to the surface and/or to a substrate table for supporting the substrate, for creating, by means of gas injected by the gas injector, a gas barrier at least between the first deposition cavity and the second deposition cavity; wherein the method further comprises heating the gas before injection of the gas by the gas injector.

In an embodiment of the method according to said further and/or additional aspect, the atomic layer deposition comprises deposition of a stack of atomic layers for manufacturing of a material arranged for use as a light emitting diode. The first reactant gas preferably comprises NH₃. The second reactant gas preferably comprises at least one gallium precursor, e.g. Ga(CH₃)₃ and/or GaCl₃. The substrate preferably comprises sapphire. Preferably, the material is arranged for use as a light emitting diode. The material may e.g. be arranged for emitting substantially blue light. Preferably, said material comprises, e.g. may substantially consists of, gallium nitride (GaN) and/or indium nitride (InN). Hence, said material may comprise, e.g. may substantially consist of, indium gallium nitride (InGaN). Depositing said material by means of atomic layer deposition may improve a layer thickness control of the material, compared to known deposition methods. Optionally, a plurality of atomic layers may be deposited, e.g. by repeatedly transporting a substrate along the first cavity containing the first reactant and the second cavity containing the second reactant. The method may comprise moving, e.g. rotating, the deposition member and the substrate with respect to each other. E.g., the method may comprise moving, e.g. rotating, the deposition member and the substrate table with respect to each other.

Optionally, a method according to the invention is carried out by means of an apparatus according to the invention.

Embodiments of the invention will now be described, by way of example only, with reference to the accompanying drawings in which corresponding reference symbols indicate corresponding parts, and in which:
Figure 1a depicts a view on an atomic layer deposition apparatus according to a first embodiment of the invention;
Figure 1b depicts a bottom view on a deposition member 33 of the apparatus of figure 1;
Figure 1c depicts a top view on the substrate table 3;
Figure 1d shows a variation of the atomic layer deposition apparatus according to the first embodiment;
Figure 2 depicts a view on an atomic layer deposition apparatus according to a second embodiment of the invention;
Figure 3 depicts a view on an atomic layer deposition apparatus according to a third embodiment of the invention; and,
Figure 4 shows the apparatus 1 in a further embodiment

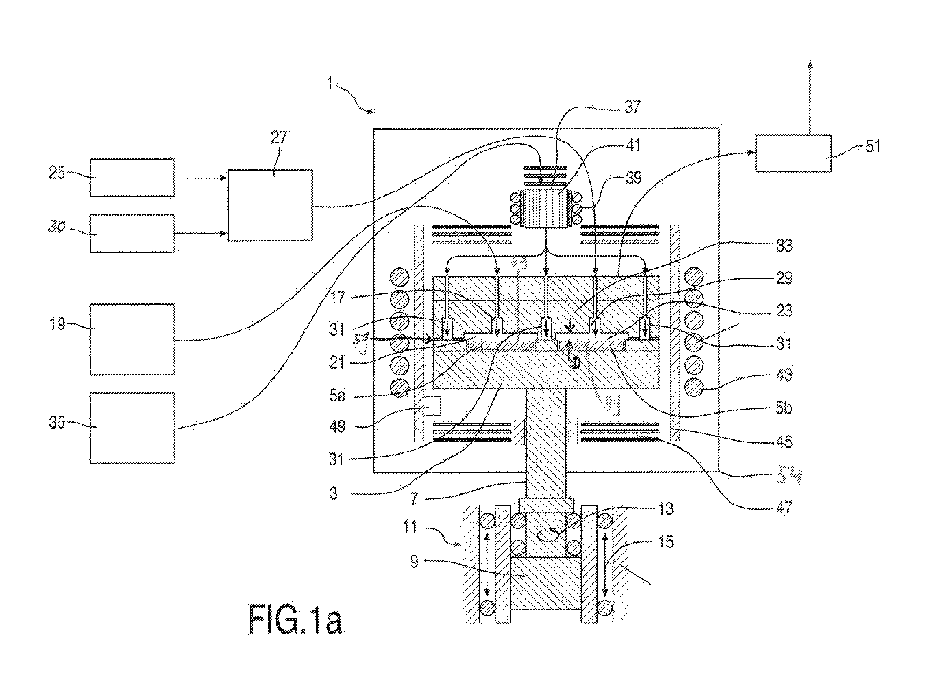

Figure 1a schematically depicts a view on an atomic layer deposition (ALD) apparatus 1 according to a first embodiment of the invention. The ALD apparatus may be provided with a substrate table 3 for supporting a substrate 5 (e.g. comprising or being made of silicon or sapphire). The substrate table 3 may be rotatable around a rotating shaft 7 with the help of a rotational motor 9. The bearing 11 of the shaft 7 allows for movement in a rotating direction 13 and a translation direction 15 perpendicular to the surface 89 of the substrate 5a, 5b. As depicted the bearing function in the rotational direction is separated from the bearing function in the translation direction. The rotational and translation function, however may also be combined in one bearing. The substrate table 3 may be moveable in the translation direction 15 by hand or with an actuator. The translation direction 15 may be necessary for lowering the substrate table 3 so that the substrate 5a, 5b may be removed from and/or loaded on the substrate table 3 or it may be necessary to adjust the distance between the deposition member 33 and the substrate table 3 to 1 -200 µm.

The apparatus 1 may be provided with a first reactant injector 17 for supplying a first reactant (for example NH₃), e.g. a mixture of reactants, from a first supply 19 to a first cavity 21, also referred to as a first deposition cavity 21, arranged within the apparatus 1 so that in use the first cavity is facing the surface of a first substrate 5a. The substrate table 3 may be provided with one or more substrates 5a, 5b. The first reactant may be reacting with the surface of the first substrate 5a and subsequently the first substrate 5a is moved away from the position facing the first cavity by the rotational motor 9 such that the substrate 5a will be positioned facing a second cavity 23, also referred to as a second deposition cavity 23. A second reactant (for example TMGa (Ga(CH₃)₃), e.g. a mixture of reactants, e.g. a mixture of TMGa and TMIn (In(CH₃)₃), may be provided from a second supply 25 to an evaporation device 27 to evaporate the second reactant if it is liquid. In the evaporation device 27 the second reactant may also be mixed with nitrogen from a nitrogen source 30. The second reactant may be provided to the second injector 29 and injected in the second cavity 23 to react with the surface of the first substrate 5a. At the same time the first substrate 5a is moved to the second cavity a second substrate 5b is moved to the first cavity 21 and a first reactant is provided to the surface of the second substrate 5b while the first substrate 5a is processed with the second reactant. By sequentially processing the surfaces of the first and second substrate 5a, 5b, with the first and second reactant by rotating the substrate table 3 a layer of controlled thickness can be deposited on the surfaces of the substrates 5a, 5b. The first and second reactants may be deposited on the surface in parallel on different locations but by movement of the substrate the first and second reactants will be deposited sequentially.

The first reactant and/or the second reactant may comprise a dopant.

In general, more than two reactants may be used to create different layers. For example, multiple different layers can be produced by using multiple reactant pairs.

It is important that the first and second reactants are not in direct contact with each other at unwanted position away from the substrate surface and/or the substrate table, because that may create contamination within the apparatus. A gas injector 31 is arranged in the deposition member so that in use the gas injector is facing the substrate and/or the substrate table 3. The gas injector may be arranged for creating, by means of gas, e.g. nitrogen, injected by the gas injector, a gas barrier at least between the first cavity 21 and the second cavity 23. Hence, direct contact between the first and second reactants away from the substrate surface may be prevented. There may be provided a gas bearing 59 created with the gas injector 31 arranged in a deposition member 33 of the apparatus 1. Gas (e.g. Nitrogen) from a gas supply 35 may be supplied to the gas bearing. Said gas preferably is inert at the increased temperature being e.g. larger than 1000 degrees Celsius, e.g. around 1100 degrees Celsius. The gas bearing has the function to keep the gap between the deposition member and the substrate to a fixed value and to separate the first and second reactants from each other using a flow that is faster than the diffusion speed of the reactants. It may be appreciated that the gas barrier may form the gas bearing.

The gas bearing may allow the deposition member 33 to approach the substrate surface and/or the substrate table 3 relatively closely. For example, in use a separation between the deposition member 33 and the substrate and/or the substrate table 3 may be within 50 micrometer or within 15 micrometer, for example in a range from 3 to 10 micrometer, for example 5 micrometer, such separation being measured in the gas bearing. Such a close approach of the deposition member 33 to the substrate surface and/or the substrate table 3 improves confinement of the first and second reactants to respectively the first and second cavity. It will be appreciated that escape of the reactants out of the cavities 21, 23 is relatively difficult because of the close approach of the deposition member 33, and the substrate 5a, 5b and/or the substrate table 3. It may thus be clear that in the cavities 21, 23 a larger separation distance D between the deposition member 33 on the one hand and the substrate 5a, 5b and/or the substrate table 3 on the other hand may be provided than in the gas bearing 59. As a result of the presence of the gas bearing 59, the deposition member 33 may in use be floating with respect to the substrate and the substrate table 3.

The cavities 21, 23 (i.e. the first cavity 21 and the second cavity 23) enable to apply process conditions for the reactants in the cavities (21, 23) that are different from process conditions in the gas bearing 59. Thus, process conditions in the cavities (21, 23) and process conditions in the gas bearing 59 can both be optimised. For example, process conditions like working temperature, gas pressures and/or exposure time of the surface to the reactants, may be set more accurately compared to a situation without the cavities (21, 23). Occurrence of transients in the precursor gas pressure can be reduced as a result of the cavities (21, 23).

The gas bearing in use typically shows a strong increase of the pressure in the gas bearing as a result of the close approach of the deposition member 33 towards the substrate surface and/or the substrate table 3. For example, in use the pressure in the gas bearing at least doubles, for example typically increases eight times, when the deposition member moves two times closer to the substrate and/or the substrate table 3. Preferably, a stiffness of the gas bearing in use is in a range from 10³ to 10⁹ Newton per meter. However, said stiffness can also be outside said range. For obtaining the gas bearing, preferably, the apparatus 1 is arranged for applying a prestressing force on the deposition member 33 directed towards the substrate surface 89. The apparatus may be arranged for counteracting the prestressing force by controlling the pressure in the gas bearing 59. In use, the prestressing force increases a stiffness of the gas bearing. Such an increased stiffness reduces unwanted movement out of the plane of the substrate surface. As a result, the deposition member 33 can be operated more closely to the substrate surface, without touching the substrate surface during deposition.

The gas from the gas supply 35 may be heated in a heater 37, which may comprise or may be formed by a first induction heater comprising electrical coils 39 surrounding a (metal) body 41 with channels. By providing an alternating current to the coils 39 the body 41 may be heated and the gas flowing trough the channels will also be heated. The gas may be heated to a gas working temperature of around 1100 °C. Such a temperature may be necessary to sustain the deposition reaction comprising TMGa. It is advantageous to heat the gas for the gas bearing because the amount of gas used in the gas bearing is large compared to the first and second reactants and in this way a lot of heat can be transported. Heating via the gas bearing may also be advantageously because the heating may occur more homogeneously in this way. Non-homogeneous heating may cause mechanical deformation of the substrate, or the apparatus and may result in a possible failure/collision. Non-homogeneous heating may also cause the deposition to occur non-homogeneously. The reactants, especially TMGa may also be unstable at the required high temperatures. TMGa may therefore not be allowed at a high temperature for too long.

An increased temperature may also facilitate some chemical reactions and it may be beneficial for crystalline deposition or (hetero-)epitaxial growth (i.e. monocrystalline film growth on monocrystalline crystal, e.g. of InGaN on sapphire).

The apparatus may be provided with an additional heater, e.g. comprising or being formed by a second induction heater 43. The second induction heater 43 may be provided with coils surrounding the substrate table 3. The second induction heater 43 may be used to heat the substrate, e.g. via the substrate table 3. The substrate table 3 may also be provided with a resistor heater or radiation heater for heating the substrate table 3. A heat shield 45, 47 may be provided between , in use, hot parts of the apparatus, such as the deposition member 33 and the substrate table 3. The heat shield may comprise a quartz shield 45 or a (multilayer) reflective foil 47. The quartz shield may preferably be used close to the first and/or second induction heater. This is because quartz will not substantially interfere with the working of the induction heaters. The coils of the induction heaters may also function as a heat shield. The multilayer may also be provided as a coating. A temperature sensor 49 may be provided to the apparatus 1 to measure the temperature of the hot parts of the apparatus. The apparatus 1 may be provided with a gas and reactants removal system 51. The gas removal system 51 may be used to remove the surplus of reactants from the cavities 21, 23 and the surplus of gas from the gas bearing. The gas may be cleaned by a scrubber before it may be exhausted. The apparatus 1 may be provided with an outer casing 54 to protect the user of the apparatus 1.

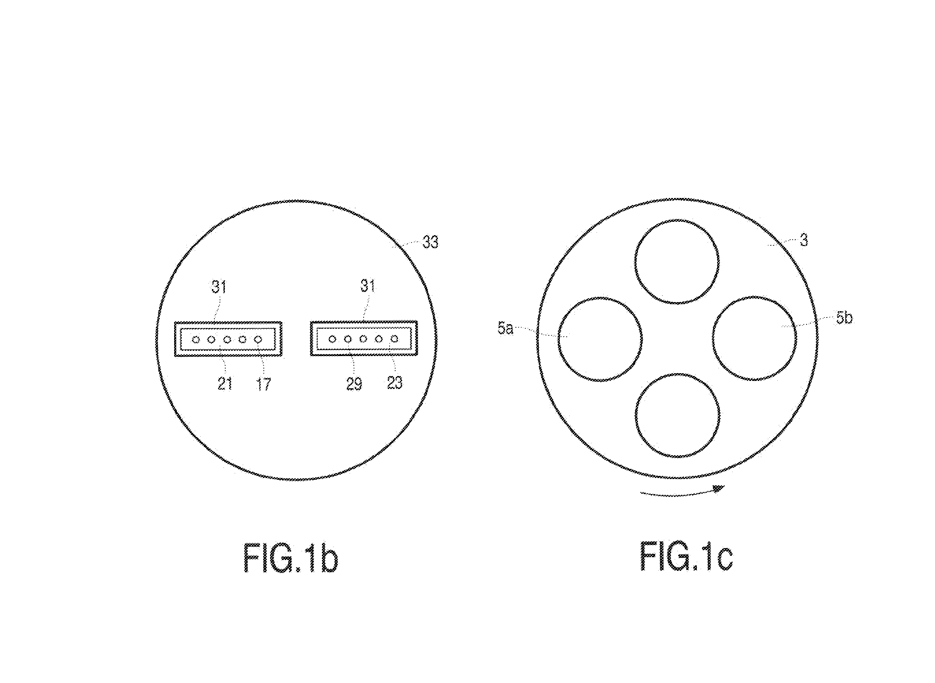

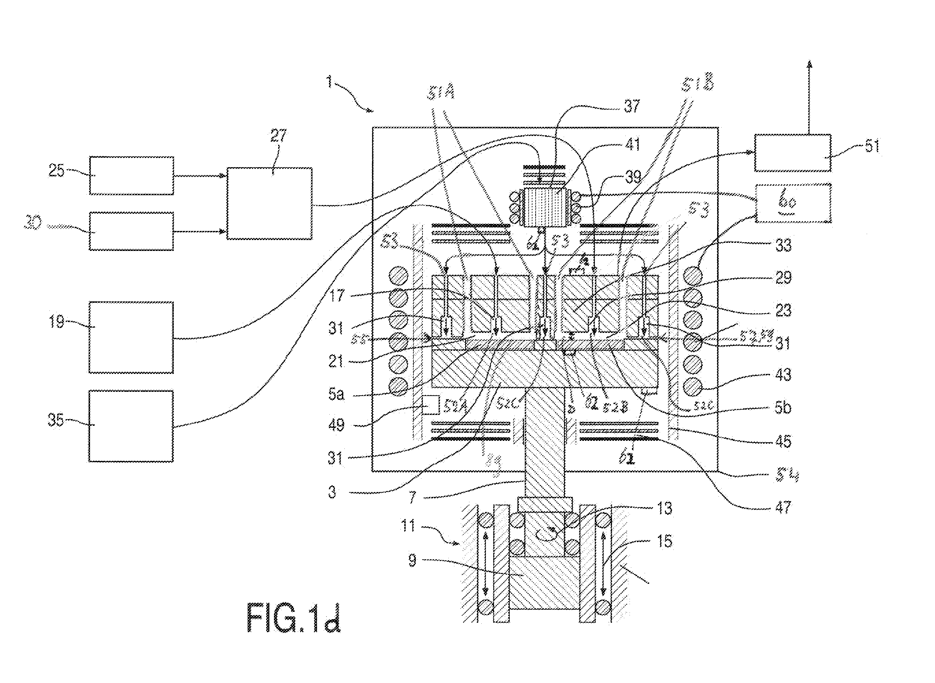

The gas injectors 31 may be facing the surface of the substrate 5a, 5b or the surface of the substrate table 3. The surface of the substrate may be heated by the gas bearing after heating of the gas to be injected by the gas injector, and/or may be heated by an additional heater, for example the second induction heater. The gas bearing may also function as a separator for the first and second reactants as is shown in figure 1b, which depicts a bottom view on a deposition member 33 of the apparatus of figure 1. It shows multiple first reactant injectors 17 and multiple second reactant injectors 29 providing reactants to their respective cavity 21, 23 and surrounded by gas injector 31. Figure 1c depicts a top view on the substrate table 3 provided with four substrates 5a, 5b.

Figure 1d shows a variation of the atomic layer deposition apparatus 1 according to the first embodiment. The variation of figure 1d may share one or more features of the apparatus 1 according to the first embodiment and/or described with reference to figures 1a-c. In the example of figure 1d, the first reactant injector 17 and the second reactant injector 29 may, at least partly, be arranged in the deposition member 33. The deposition member 33 and/or the substrate table 3 may have a gas inlet 53. The gas injector 31 may be in fluid communication with the gas inlet 53 for transporting gas from the gas inlet, towards the substrate and/or the substrate table 3. The gas injector 31 may be arranged in the deposition member 33 so that in use the gas injector 31 is facing the substrate 5a, 5b and/or the substrate table 3. Hence, the gas injector may be arranged in the deposition member 33 so that in use the gas injector is facing a space 55 between the deposition member 33 and the substrate 51, 5b and/or the substrate table 3.

The gas injector 31 may be arranged for, by means of gas injected by the gas injector, creating a gas barrier 57 at least between the first and second cavity (21, 23). The gas injector 31 may further be arranged for, by means of gas injected by the gas injector 31, creating a gas bearing 59 between the deposition member 33 and the surface of the substrate and/or between the deposition member 33 and the substrate table 3. In use, the gas bearing 59 may thus be bearing the deposition member 33 with respect to the surface 89 of the substrate 5 and/or the substrate table 3.

The apparatus 1 may comprise the heater 37 for heating the gas that is to be injected by the gas injector 31. The apparatus 1 may further comprise the additional heater for heating the deposition member 33 and the substrate table 3, and for heating the substrate, e.g. via the substrate table 3. However, the additional heater may, additionally or alternatively to heating the substrate via the substrate table 3, heat the substrate directly. Such direct heating may e.g. be performed if the substrate comprises, e.g. substantially consists of, a conductive material and the heater 37 is formed by the second induction heater, The heater 37 may be provided outside the deposition member 33 and the substrate table 3, so that, in use, the gas transported from the gas inlet and injected by the gas injector is heated by the heater 37 before said gas enters the gas inlet and the deposition member 33, when the deposition member 33 is heated by the additional heater. More in general, after having passed the gas inlet, a temperature of the gas may remain substantially constant, e.g. may vary at most 10% or 20% from its temperature at the gas inlet, before being drained away from the substrate and/or the substrate table.

The apparatus 1 may comprising a controller 60 for controlling heat supplied by the heater 37 and the additional heater. The heater 37 may be arranged for heating the gas that is to be injected by the gas injector to a gas working temperature. The additional heater may be arranged for heating the deposition member 33 to a deposition member working temperature. The additional heater may be arranged for heating the substrate table 3 to a substrate table working temperature. The additional heater may be arranged for heating the substrate to a substrate working temperature, e.g. via the substrate table 3. The controller may be arranged for substantially equalizing the gas working temperature, the deposition member working temperature, the substrate table working temperature, and/or the substrate working temperature. As a result, said temperature may be in a range of 1100 degrees Celsius plus or minus 100 degrees Celsius. i.e. in a range from 1000 to 1200 degrees Celsius. By means of such equalizing, thermo-mechanical deformation of the substrate table 3, the substrate, and the deposition member 33 may be acceptable. Hence, the apparatus 1 may function properly.

For improving controlling, the controller 60 may be provided with at least one temperature feed-back element, e.g. at least one temperature sensor 49, at least one thermocouple 62 and/or at least one pyrometer. The temperature feed-back elements may be individually in thermal communication with the substrate table 3, the deposition member 33, the heater 37, and/or the substrate. A temperature determined by means of a temperature feed-back element may be communicated to the controller 60. The controller may be arranged for controlling the heater 37 and/or the additional heater based on temperatures determined by means of the temperature feed-back elements, e.g. the temperature sensors 49, the thermocouples 62, and/or the pyrometers.

It may thus be clear that, more in general, the deposition member 33 and/or the substrate table 3 may form a thermal mass that is arranged in the apparatus 1 for being responsive to heat provided by the additional heater. The heater 37 may be provided outside the thermal mass, so that, in use, the gas transported from the gas inlet and injected by the gas injector is heated by the heater 37 before said gas enters the thermal mass when the thermal mass is, in use, heated by the additional heater. Thus, the terms 'deposition member' and 'substrate table' used here may indicate parts of the apparatus 1 that are primarily responsive to the additional heater. For example, the additional heater may be or may comprises an induction heater, e.g. the second induction heater 43, and the deposition member and/or the substrate table 3 comprises, preferably substantially consists of, a conductive material that is responsive to the induction heater. Parts of the apparatus 1 that are not responsive to the additional heater, e.g. are positioned away from the additional heater and/or are not surrounded by the additional heater, may preferably not form part of the thermal mass.

For exhausting gas by means of the gas removal system 51, the first cavity 21 may be provided with a first reactant drain 51A and the second cavity 23 may be provided with a second reactant drain 51B. The first reactant drain may be positioned in the first cavity 21 for substantially preventing flow of the first reactant out of the first cavity 21. The second reactant drain may be positioned in the second cavity 23 for substantially preventing flow of the second reactant out of the second cavity 23. Hence, more in general, the first reactant injector 17, e.g. a first outlet 52A of the first reactant injector 17, may be positioned in the first cavity 21. The first reactant drain 51A may be positioned in the first cavity 21. The second reactant injector 29, e.g. a second outlet 52B of the second reactant injector 29, may be positioned in the second cavity 23. The second reactant drain 51B may be positioned in the second cavity 23. In the gas bearing, e.g. near or adjacent to an outlet 52C of the gas injector 31, a separation distance D between the deposition member 33 and the substrate and/or the substrate table 3 may, in use, be at least 3 micrometers, at least 5 micrometers, at least 10 micrometers, and/or at most 70, 50, 30, or 15 micrometers. Additionally or alternatively, in the first and/or second cavity the separation distance D between the deposition member and the substrate and/or the substrate table 3 may, in use, be at most 5000 micrometers, at most 2000 micrometer, at most 1000 micrometers, at most 500 micrometers, at most 200 micrometers, at most 100 micrometers, at most 50 micrometers, and/or at least 25 micrometers. A difference between the separation D in the first and/or second cavity on the one hand, and the separation distance D in the gas bearing on the other hand, may, in use, be in a range from 25 micrometers to 500, 1000, 2000, or 5000 micrometers.

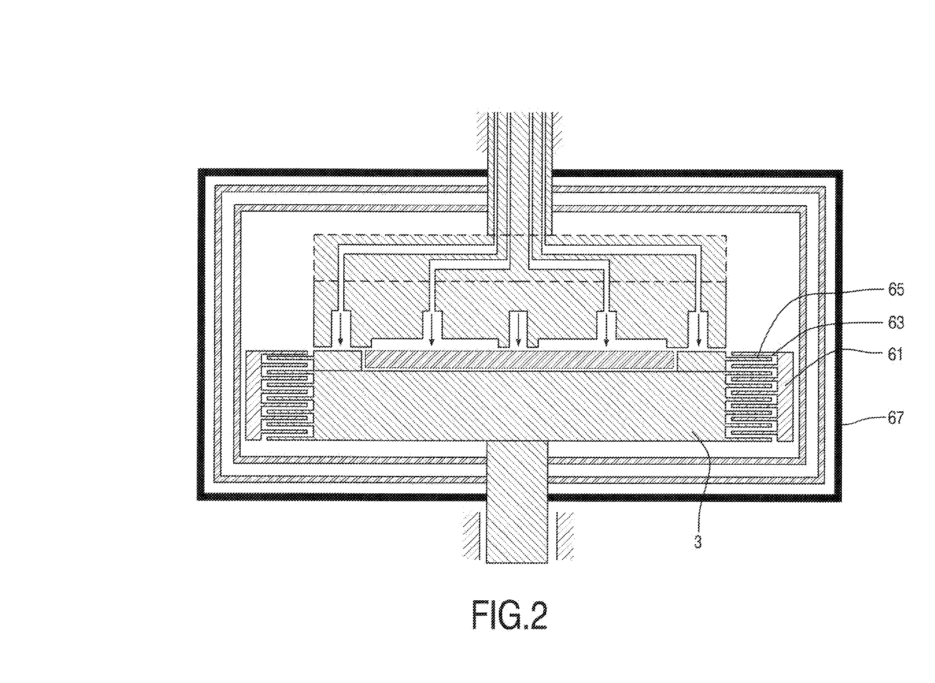

Figure 2 depicts a view on an atomic layer deposition apparatus according to a second embodiment of the invention. The substrate table 3 may be heated with a table heater 61 which is provided with heating fins 63 for transporting the heat to the substrate table 3 via substrate fins 65. The heater 61 may be using a resistor or combustion as a source of heat. The table heater 61 may be used as an addition to the gas heater 37 in figure 1, e.g. may be comprised by the additional heater. The heat shield 67 may be a (multilayer) reflective heat shield in this case.

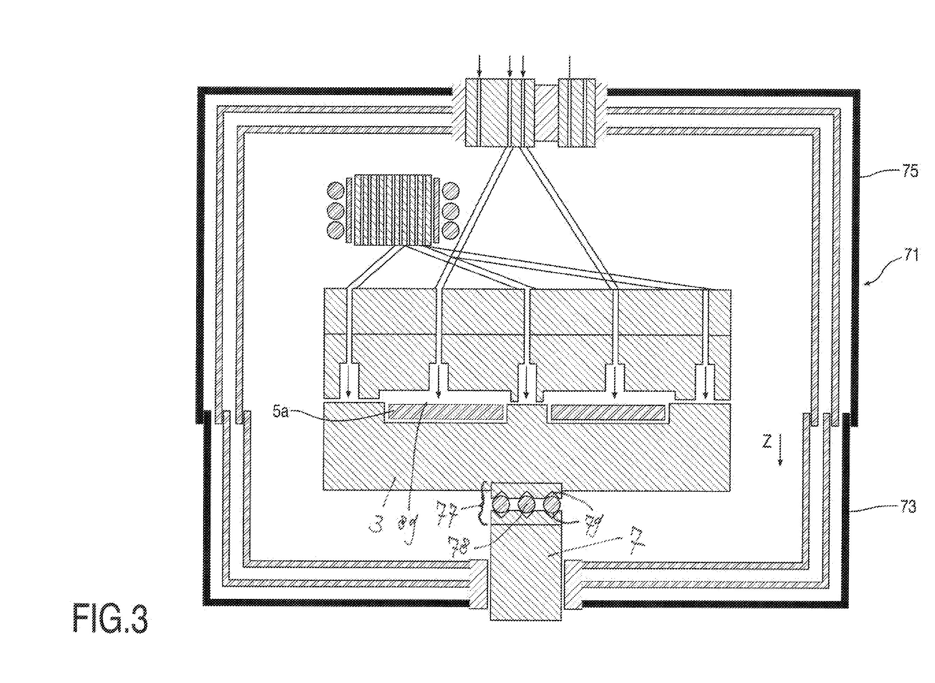

Figure 3 depicts a view on an atomic layer deposition apparatus according to a third embodiment of the invention. The heat shield 71 may be divided in a lower heat shield 73 and an upper heat shield 75. The atomic layer deposition apparatus may be opened up by moving the lower heat shield 73 and the upper heat shield 75 with respect to each other in the z-direction which is substantially perpendicular to the surface 89 of the substrate 5a.

Figure 3 also shows a kinematic mount 77 for mounting the substrate table 3 on the shaft 7. The kinematic mount 77 may be provided with three balls 78. The kinematic mount may be provided with notches 79. The notches 79 may be V-shaped. Hence, the notches 79 may show a V-shape in a cross section perpendicular to a length direction of the notches (as visible in figure 3). The notches 79 may extend in a radial pattern. Such a kinematic mount may have the advantage that the substrate table 3 may be conveniently removed from the shaft, while it can be afterwards mounted thereon it substantially the same position as before removing. Alternatively or additionally, such a kinematic mount may provide a rather efficient thermal barrier between the substrate table 3 and the shaft 7. Thus, the kinematic mount 77 may substantially prevent heating of the shaft via the substrate table 3. The kinematic mount may be generally applied in the apparatus 1.

In an alternative embodiment the substrate table 3 may be provided with a gas bearing for supporting the substrate. The substrate may be moveable over the gas bearing in a rotary or a translation direction.

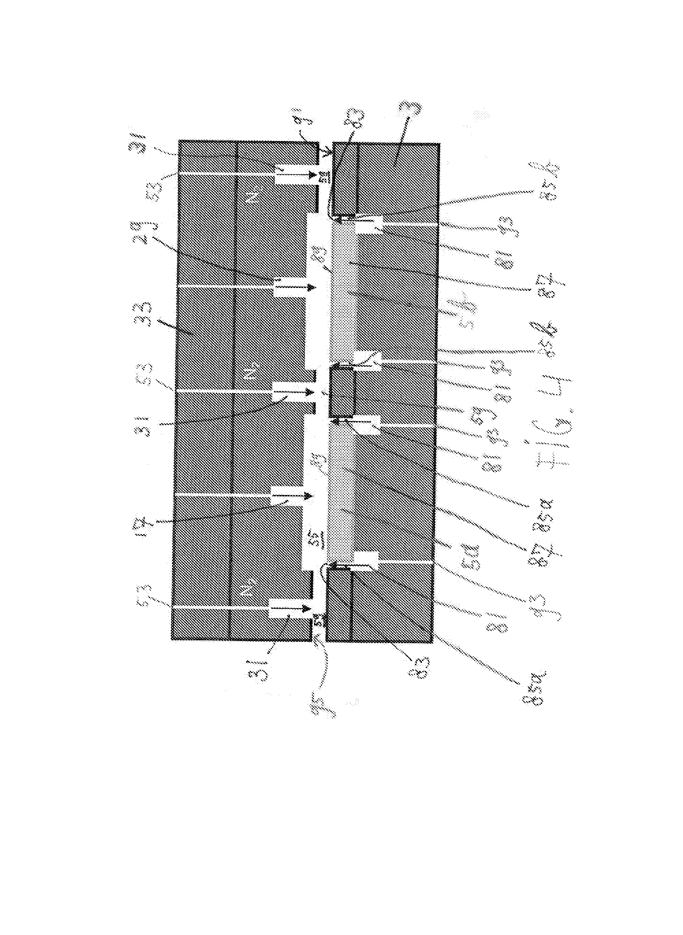

Figure 4 shows the apparatus 1 in a further embodiment, that may be combined with features of other embodiments. The substrate table 3 may be provided with an additional gas injector 81 for supplying an additional gas, e.g. a cleaning gas, from the substrate table 3 towards the space 55. The additional gas, e.g. the cleaning gas, may be of similar composition as the gas injected by the gas injector 31. The cleaning gas injector 81, i.e. an outlet 83 of the cleaning gas injector, may, in use, be positioned below the substrate or in a vicinity of the substrate or near the substrate. Optionally, the cleaning gas outlet may, at least partly, be arranged below the substrate. The additional gas injector 81, e.g. the cleaning gas injector, may in use at least partly be positioned in the substrate table 3 for generating a cleaning gas flow in a substrate space 85a, 85b between the substrate table 3 and the substrate 5a, 5b. In this way, deposition of atomic layers in the substrate spaces 85a, 85 may be prevented or at least hindered. Hence, contamination of the apparatus with particles originating from atomic layers that are generated from deposits in the substrate spaces 85a, 85b during removal at mounting of the substrate, may be substantially prevented or at least may be decreased. The substrate table 3 may be provided with at least one table cavity 87 for receiving therein at least one substrate 5a, 5b. A depth of the table cavities may be arranged for having, in use, the substrate surface 89 aligned with an, in use, upper plane 91 of the substrate table 3. The features of the further embodiment of figure 4 may individually be applied generally.

More in general, the heater 37 may further be arranged for heating the additional gas that is to be injected by the additional gas injector 81. The substrate table 3 may have an additional gas inlet 93 for the gas that is to be injected by the additional gas injector 81, wherein the additional gas injector 81 is in fluid communication with the additional gas inlet 93 for transporting the gas from the additional gas inlet 93. Such transporting may be towards the space 55 between the deposition member 33 and the substrate 5a, 5b and/or the substrate table 3. The heater 37 may be provided outside the deposition member 33 and the substrate table 3, so that, in use, the additional gas transported from the additional gas inlet 93 and injected by the additional gas injector 81 is heated by the heater 37 before said additional gas enters the additional gas inlet and/or the substrate table 3 when, in use, the substrate table 3 is heated by the additional heater.

In a further alternative embodiment the substrate may be moveable in a translation direction. This may be accomplished by having a substrate table 3 that is moveable in a translation direction or by having the substrate directly supported on a gas bearing. The reactant cavities in such apparatus may also be displaced in a translation direction with respect to each other. For more information with respect to such apparatus reference is made to EP2159304.

Further aspects of the invention may comprise: an apparatus for atomic layer deposition on a surface of a substrate, the apparatus comprising a first reactant injector for supplying a first reactant from a first supply to a first cavity arranged within the apparatus so that in use the first cavity is facing the surface, comprising a second reactant injector for supplying a second reactant from a second supply to a second cavity arranged within the apparatus so that in use the second cavity is facing the surface, and comprising a gas injector arranged within the apparatus so that in use the gas injector is facing the surface for creating a gas barrier with gas, wherein the apparatus comprises a heater for heating the gas; an apparatus for atomic layer deposition on a surface of a substrate, the apparatus comprising: a first reactant injector for supplying a first reactant from a first supply to a first cavity arranged within the apparatus so that in use the first cavity is facing the surface and/or a substrate table of the apparatus for supporting the substrate; a second reactant injector for supplying a second reactant from a second supply to a second cavity arranged within the apparatus so that in use the second cavity is facing the surface and/or the substrate table; and, a gas injector arranged within the apparatus so that in use the gas injector is facing the surface and/or the substrate table for creating, by means of gas injected by the gas injector, a gas barrier at least between the first cavity and the second cavity; wherein the apparatus comprises a heater for heating the gas that is to be injected by the gas injector; an apparatus according to the invention, provided with the substrate table for supporting the substrate; an apparatus according to the invention, wherein the first reactant injector, the second reactant injector and the gas injector are provided in a deposition member of the apparatus; an apparatus according to the invention, wherein the gas bearing is bearing the deposition member with respect to the surface of the substrate; an apparatus according to the invention, wherein the apparatus comprises an additional heater for heating of the substrate, the additional heater comprising a second induction heater being provided with coils surrounding the substrate table; a method for atomic layer deposition on a surface of a substrate, the method comprising supplying a first reactant from a first supply to a first deposition cavity so as to bring the first reactant in contact with the surface, comprises supplying a second reactant from a second supply to a second deposition cavity so as to bring the second reactant in contact with the surface; and comprises supplying a gas via a gas injector to the surface; wherein the method further comprises heating the gas; a method for atomic layer deposition on a surface of a substrate, the method comprising: supplying a first reactant from a first supply to a first deposition cavity so as to bring the first reactant in contact with the surface; supplying a second reactant from a second supply to a second deposition cavity so as to bring the second reactant in contact with the surface; and supplying a gas via a gas injector to the surface and/or to a substrate table for supporting the substrate, for creating, by means of gas injected by the gas injector, a gas barrier at least between the first deposition cavity and the second deposition cavity; wherein the method further comprises heating the gas before injection of the gas by the gas injector; an apparatus according to the invention, wherein the substrate table is provided with a gas bearing for supporting the substrate; an apparatus according to the invention, wherein the heat shield comprises a reflective material; an apparatus according to the invention, wherein the heat shield comprises multi layers of reflective material; an apparatus according to the invention, wherein the heat shield is being provided between the body with channels and the first inductor; an apparatus according to the invention, wherein the substrate table is moveable with respect to the deposition member in a direction perpendicular to a main surface, e.g. the main surface 95 shown in figure 4, of the deposition member so as to open the apparatus and to allow the substrate to be loaded or removed; an apparatus according to the invention, wherein the substrate table and the deposition member are made of a material that can withstand temperatures up to 1100 degrees Celsius; an apparatus according to the invention, wherein the substrate is made of sapphire; an apparatus according to the invention, wherein the deposition member and/or the substrate table are made of an alloy of molybdenum; and an apparatus according to the invention, wherein the induction heater is provided with coils surrounding the deposition member and/or the substrate table.

While specific embodiments of the invention have been described above, it is appreciated that the invention may be practiced otherwise than as described or with additional features as is described. As a first example, the heater, the additional heater, and/or a further heater, may be arranged for heating the first and/or the second reactant to a working temperature of the first and/or the second reactant. The further heater may be arranged in the deposition member. Thus, the first and/or the second reactant may be heated in a vicinity of respectively the first and/or second cavity. Especially for TMGa, and possibly for other gallium precursors, this is beneficial as such precursors may deteriorate when exposed to high temperatures for a too long time. The controller may further be arranged for controlling heat supplied by the further heater. The controller may be arranged for controlling, preferably for substantially equalizing, the gas working temperature, the deposition member temperature, the substrate table working temperature, the substrate working temperature, the first reactant working temperature, and/or the second reactant working temperature. As a second example, the deposition member may be provided with a plurality (e.g. two or three or more than three) of first cavities and/or a plurality (e.g. two or three or more than three) of second cavities. Having more cavities may enable a faster and/or more versatile deposition process. The first reactant injector may be arranged for supplying the first reactant to the plurality of first cavities. The second reactant injector may be arranged for supplying the second reactant to the plurality of second cavities. However, alternatively or additionally, the deposition member may be provided with a plurality of first reactant injectors and cavities of the plurality of first cavities may be individually provided with a first reactant injector of the plurality of first reactant injectors. Similarly, the deposition member may be provided with a plurality of second reactant injectors and second cavities of the plurality of second cavities may be individually provided with a second reactant injector of the plurality of second reactant injectors. An embodiment of an apparatus according to the invention may comprise at least two second cavities, at least two second reactant injectors, at least two first cavities, at least two first reactor injectors, a first supply, and at least two second supplies. A first one of the second reactant injectors may be arranged for supplying a first one of the second reactants, e.g. TMGa, from a first one of the second supplies to a first one of the second cavities. A second one of the second reactant injectors may be arranged for supplying a second one of the second reactants, e.g. TMIn, from a second one of the second supplies to a second one of the second cavities. The second cavities may be arranged in the deposition member so that in use the second cavities are facing the surface and/or the substrate table. A first one of the first reactant injectors may be arranged for supplying the first reactant, e.g. NH₃, from the first supply to a first one of the first cavities that may be arranged in the deposition member so that in use the first one of the first cavities is facing the surface and/or the substrate table. A second one of the first reactant injectors may be arranged for supplying the first reactant, e.g. NHs, from the first supply to a second one of the first cavities that may be arranged in the deposition member so that in use the second one of the first cavities is facing the surface and/or the substrate table. Thus, the deposition member may be provided with at least two second cavities and at least two first cavities. This embodiment may combine well with a rotary substrate table.

The description is intended to be illustrative, not limiting. Thus it will be apparent to the one skilled in the art that the modification may be made to the invention as described without departing from the scope of the claims as set out below.

## Claims

1. Apparatus for atomic layer deposition on a surface of a substrate, the apparatus comprising:
a deposition member;
a substrate table for supporting the substrate;
a first reactant injector for supplying a first reactant from a first supply to a first cavity being arranged in the deposition member so that in use the first cavity is facing the surface and/or the substrate table;
a second reactant injector for supplying a second reactant from a second supply to a second cavity being arranged in the deposition member so that in use the second cavity is facing the surface and/or the substrate table;
a gas injector, at least partly being arranged in the deposition member so that in use the gas injector is facing the substrate and/or the substrate table, the gas injector being arranged for creating, by means of gas injected by the gas injector, a gas barrier at least between the first cavity and the second cavity, and optionally being arranged for creating, by means of the gas injected by the gas injector, a gas bearing between the deposition member and the surface of the substrate and/or between the deposition member and the substrate table, wherein, in use, the gas bearing is bearing the deposition member with respect to the surface of the substrate and/or the substrate table;
a heater for heating the gas that is to be injected by the gas injector; and
an additional heater for heating the deposition member and the substrate table, and for heating the substrate, optionally via the substrate table;
wherein the deposition member and optionally the substrate table have a gas inlet for the gas that is to be injected by the gas injector, wherein the gas injector is in fluid communication with the gas inlet for transporting the gas from the gas inlet;
wherein the heater is provided outside the deposition member and the substrate table, so that, in use, the gas transported from the gas inlet and injected by the gas injector is heated by the heater before said gas enters the gas inlet and the deposition member when, in use, the deposition member is heated by the additional heater.

2. The apparatus according to claim 1, wherein the gas injector is provided at least in between the first and second reactant injector so as to separate the first and the second reactants.

3. The apparatus according to claim 1 or 2, wherein the substrate table is a rotary table for in use rotating the substrate.

4. Apparatus according to one of claims 1-3, comprising a controller for controlling heat supplied by the heater and the additional heater, wherein the heater is arranged for heating the gas that is to be injected by the gas injector to a gas working temperature; and wherein the additional heater is arranged for heating the deposition member to a deposition member working temperature and for heating the substrate table to a substrate table working temperature, and for heating the substrate to a substrate working temperature, optionally via the substrate table; wherein the controller is arranged for controlling, preferably for substantially equalizing, the gas working temperature, the deposition member temperature, the substrate table working temperature, and/or the substrate working temperature.

5. Apparatus according to one of claims 1-4, wherein the first cavity is provided with a first reactant drain and/or the second cavity is provided with a second reactant drain, wherein the first reactant drain is positioned in the first cavity for substantially preventing flow of the first reactant out of the first cavity and/or the second reactant drain is positioned in the second cavity for substantially preventing flow of the second reactant out of the second cavity.

6. Apparatus according to one of claims 1-5, wherein the deposition member and/or the substrate table forms a thermal mass that is arranged in the apparatus for being responsive to heat provided by the additional heater.

7. Apparatus according to one of claims 1-6, wherein the additional heater comprises an induction heater and the deposition member and/or the substrate table comprises, preferably substantially consists of, a metallic material that is responsive to the induction heater.

8. The apparatus according to any of claims 1 to 7, wherein the heater comprises a first induction heater, the induction heater being provided with coils surrounding a body with channels for heating the gas.

9. The apparatus according to at least claim 7 of claims 1-8, wherein the additional heater comprises a second induction heater being provided with coils surrounding the deposition member and/or the substrate table.

10. The apparatus according to claim 9, wherein the apparatus is being provided with a heat shield, the heat shield defining an inside of the heat shield being provided with the deposition member and/or the substrate table and an outside of the heat shield being provided with the coils of the second induction heater.

11. The apparatus according to claim 9 or 10, wherein the heat shield is being provided between the body with channels and the first inductor.

12. The apparatus according to any of claims 1 to 11, wherein the substrate table is moveable with respect to the deposition member in a direction perpendicular to a main surface of the deposition member so as to open the apparatus and to allow the substrate to be loaded or removed.

13. Method for atomic layer deposition on a surface of a substrate, the method comprising:
providing a deposition member;
supporting the substrate by means of a substrate table;
supplying a first reactant from a first supply to a first deposition cavity that faces the substrate and/or the substrate table so as to bring the first reactant in contact with the surface;
supplying a second reactant from a second supply to a second deposition cavity that faces the substrate and/or the substrate table so as to bring the second reactant in contact with the surface;
injecting a gas via a gas injector to the surface and/or the substrate table, and, by means of the gas injected by the gas injector, creating a gas barrier at least between the first deposition cavity and the second deposition cavity and optionally creating a gas bearing between the deposition member and the surface of the substrate and/or between the deposition member and the substrate table, so that the gas bearing is bearing the deposition member with respect to the surface of the substrate and/or the substrate table;
providing a heater for heating the gas before injection by the gas injector;
providing an additional heater for heating the deposition member and the substrate table, and for heating the substrate, optionally via the substrate table;
transporting the gas that is to be injected by the gas injector in the deposition member from a gas inlet of the deposition member that is in fluid communication with the gas injector;
wherein the method comprises providing the heater outside the deposition member and the substrate table, and comprises heating the gas transported from the gas inlet and injected by the gas injector before said gas enters the gas inlet and the deposition member when the deposition member is heated by the additional heater.

14. Method according to claim 13, comprising heating, by means of the heater, the gas that is to be injected by the gas injector to a gas working temperature; comprising heating, by means of the additional heater, the deposition member to a deposition member working temperature, heating the substrate table to a substrate table working temperature, and heating the substrate to a substrate working temperature, optionally via the substrate table; the method comprising controlling the heating by means of the heater and the additional heater for controlling, preferably for substantially equalizing, the gas working temperature, the deposition member temperature, the substrate table working temperature, and/or the substrate working temperature.

15. Method according to claim 13 or 14, carried out by means of an apparatus according to one of claims 1-12.
